# EUROPÄISCHE PATENTSCHRIFT

(11) **EP 3 443 417 B1**
(45) Veröffentlichungstag und Bekanntmachung des Hinweises auf die Patenterteilung: **03.06.2020**
(21) Anmeldenummer: 17718880.2
(22) Anmeldetag: 14.04.2017
(51) Int. Cl.: G03F 7/20, H01L 21/687

(54) **VORRICHTUNG ZUR BELICHTUNG EINES SUBSTRATS**
VORRICHTUNG ZUR BELICHTUNG EINES SUBSTRATS
DISPOSITIF D'INSOLATION D'UN SUBSTRAT

(30) Priorität: 15.04.2016 DE 102016107001
(43) Veröffentlichungstag der Anmeldung: 20.02.2019
(73) Patentinhaber: IST METZ GmbH, 72622 Nürtingen (DE)
(72) Erfinder: FUCHS, Günter, 73252 Lenningen (DE); SÄNGER, Robert, 72644 Oberboihingen (DE); JAHN-QUADER, Uwe, 72658 Bempflingen (DE)
(74) Vertreter: Pfiz, Thomas
(86) Internationale Anmeldenummer: PCT/EP2017/059069
(87) Internationale Veröffentlichungsnummer: WO 2017/178651

(56) Entgegenhaltungen:
- EP-A2- 1 107 066
- EP-A2- 1 783 555
- US-B1- 6 204 509

## Beschreibung

Die Erfindung betrifft eine Vorrichtung gemäß dem Oberbegriff des Patentanspruchs 1.

Die Verwendung von optischen Masken zur Übertragung einer Information oder einer flächigen Struktur auf ein Substrat ist bekannt und wird beispielsweise in der Halbleiterindustrie zur Herstellung von Leiterbahnen oder Halbleiterstrukturen wie Transistoren oder integrierte Schaltungen verwendet. Insbesondere werden Masken auch zur Herstellung von Displays verwendet, wobei hierbei teilweise Glas- oder Quarzmasken mit einer Größe von mehreren Quadratmetern zum Einsatz kommen, um in einem Prozessschritt beispielsweise eine Leiterbahnanordnung von der Maske auf ein photostrukturierbares Displayglas oder auf eine auf dem Displayglas befindliche photoempfindliche Schicht zu übertragen. Es ist dabei üblich, dass das Displayglas mehrere Fertigungsnutzen für entsprechende Einzelprodukte beinhaltet, so dass in einem Prozessschritt beispielsweise acht Displays mit einer jeweiligen Größe von beispielsweise 65" bearbeitet werden können.

Die Übertragung der Strukturen erfolgt hierbei dadurch, dass eine auf dem Displayglas in einem vorherigen Schritt aufgebrachte photoempfindliche Schicht über die Maske belichtet wird, wodurch die in der Maske beinhaltete Flächenstruktur auf die photoempfindliche Schicht des Displayglases übertragen wird. In einem nachfolgenden Schritt wird dann der Photolack der unbelichteten Bereiche entfernt und in den nun freiliegenden Bereichen beispielsweise Leiterbahnen aufgebracht. Anschließend wird dann der belichtete Photolack entfernt und das Displayglas steht für einen weiteren Prozessschritt, beispielsweise zum Aufbringen von Halbleiterschichten zur Verfügung.

Es ist dabei prozesstechnisch von Vorteil, die Maske in einer horizontalen Lage zu halten und die aus einer Anzahl von Lampen und einer entsprechenden angepassten Optik bestehende Belichtungseinheit oberhalb der Maske anzuordnen, so dass die Maske senkrecht von oben bestrahlt wird. Das zu belichtende Substrat wird dann während des Belichtungsprozesses von unten an die Maske herangeführt und während des Belichtungsprozesses in einer konstanten Lage gehalten.

Zur Erzielung einer möglichst randscharfen Abbildung und zur Realisierung möglichst feiner Strukturen ist es dabei erforderlich, den Abstand zwischen Maske und Substrat über den gesamten Arbeitsbereich konstant und möglichst gering zu halten. Hierzu ist es insbesondere erforderlich, die horizontal angeordnete Maske mit einer hohen Planität zu halten, um so möglichst keine Wölbung oder Welligkeit zu erzielen, was zu lokal unterschiedlichen Abständen zu dem Substrat und damit zu lokal unterschiedlichen Belichtungsergebnissen führen würde.

Erschwerend kommt dabei hinzu, dass die verwendeten Masken jeweils dünne Glasscheiben darstellen, deren Dicke im Bereich von wenigen Zehnteln Millimetern bis zu mehreren Millimetern liegt und deren Größe bei einigen Quadratmetern liegen kann. Es ist daher erforderlich, die jeweilige Maske nicht nur an Ihren Rändern, sondern auch über ihre Fläche verteilt an mehreren Bereichen zu halten und auszurichten, um so die Durchbiegung aufgrund des Eigengewichts der Maske auf ein vertretbares Maß zu reduzieren.

In diesem Zusammenhang wird in der JP002009237442A vorgeschlagen, eine transparente Trägerplatte zu verwenden, welche auf der zur Maske zugewandten Seite eine oder mehrere Nuten aufweist, über welche ein Vakuum zwischen Trägerplatte und Maske aufgebaut werden kann, wodurch die Maske plan an die Trägerplatte angepresst wird. Nachteilig hierbei ist insbesondere bei der Verwendung von sehr großen Masken von mehreren Quadratmetern Fläche, dass die Trägerplatte ihrerseits sehr groß und schwer wird und zudem eine sehr hohe Planität aufweisen muss. Nachteilig ist weiterhin, dass eine solche Trägerplatte extrem herstellungsaufwändig wird und damit nicht wirtschaftlich ist.

In der JP002011155108A wird alternativ vorgeschlagen, die Maske mittels einer Anzahl von optisch transparenten Leisten zu halten. Hierzu weist jede Leiste eine zur Maskenseite hin gewandte Nut auf, welche mit einem Vakuum beaufschlagt werden kann, wodurch die Maske angesaugt und gehalten wird. Nachteilig hierbei ist, dass die optisch transparenten Leisten während des Belichtungsprozesses als optische Elemente wirken, wodurch die Homogenität der Bestrahlung in der Prozessebene beeinträchtigt wird und lokal unterschiedliche Belichtungsergebnisse erzielt werden. Problematisch ist weiterhin, dass die Leisten über Ihre Länge eine hohe Geradheit und Planität und Steifheit aufweisen müssen, um die erforderliche Planität der Maske in der Prozessebene zu gewährleisten. Nachteilig ist weiterhin, dass eine Anpassung der genannten Vakuumleisten an Masken mit einer unterschiedlichen Anzahl und Anordnung der Nutzen nicht oder nur sehr schwierig realisiert werden kann, so dass einzelne Nutzen durch die Einwirkung der Halteleisten im optischen Strahlengang nicht optimal belichtet werden.

Eine weitere Vorrichtung, bei der die Maske über Vakuumkanäle gehalten wird, ist in EP 1 107 066 A2 gezeigt.

Aufgabe der Erfindung ist es, die genannten Nachteile zu beheben und ein Belichtungssystem für eine Maske zu schaffen, welches es ermöglicht, auch großflächige Masken mit einer wahlweise unterschiedlichen Anzahl von Nutzen zu verwenden, ohne dass die Belichtung eines Nutzens beeinträchtigt wird.

Zur Lösung dieser Aufgabe wird die im Patentanspruch 1 angegebene Merkmalskombination vorgeschlagen. Vorteilhafte Ausgestaltungen und Weiterbildungen der Erfindung ergeben sich aus den abhängigen Ansprüchen.

Dementsprechend wird erfindungsgemäß vorgeschlagen, die Maske über eine Aufnahme- und Haltevorrichtung mit der mindestens einen Belichtungseinheit verbunden ist und an der Aufnahme- und Haltevorrichtung durch Unterdruck gehalten ist, wobei die Maske über Abstützelemente in einer planen und zum Substrat parallelen Ausrichtung abgestützt ist.

Erfindungsgemäß ist die Belichtungseinrichtung an einer Seite einer Vakuum- bzw. Unterdruckkammer angeordnet, während die Aufnahme- und Haltevorrichtung für die Maske an der gegenüberliegenden Seite der Unterdruckkammer angebracht ist. Erfindungsgemäß verschließt die Maske eine Durchstrahlöffnung der Unterdruckkammer, so dass die Unterdruckwirkung erhalten wird.

Eine besonders vorteilhafte Ausführung sieht vor, dass die Maske in einem vorzugsweise austauschbaren Halterahmen als Aufnahme- und Haltevorrichtung aufgenommen ist. Der Halterahmen begrenzt somit eine Rahmenöffnung für den Durchtritt der Strahlung und kann seinerseits an der Vakuumkammer lösbar befestigt sein. Zugleich verschließt die Maske die Rahmenöffnung.

Vorteilhafterweise sind Halterungen an dem Halterahmen oder an der Belichtungseinheit zur Aufnahme und Fixierung der die Maske abstützenden Abstützelemente vorgesehen. Zweckmäßig sind die Halterungen an dem Halterahmen durch eine an der Rahmeninnenseite umlaufende Nut zum Verschieben der Abstützelemente und durch Fixierelemente zur Fixierung der Abstützelemente in der Nut gebildet. Die Halterungen können auch durch stabförmige Abstützelemente gebildet sein, die senkrecht zu der Maske ausgerichtet sind.

Um eine vorteilhafte Anpassung an die jeweilige Struktur der Maske zu ermöglichen, ist es vorteilhaft, wenn die Abstützelemente in dem Öffnungsbereich des Halterahmens frei bzw. variabel positionierbar und fixierbar sind.

Günstig ist es auch, wenn die Abstützelemente als Stäbe mit gleicher oder unterschiedlicher Querschnittsfläche ausgeführt sind. Dabei können die Abstützelemente mit Aussparungen versehen sein und über die Aussparungen miteinander zu einer Gitterstruktur verbindbar sein.

Erfindungsgemäß ist vorgesehen, dass die Abstützelemente die Maske über punktartige oder linienartige Auflagebereiche abstützen.

Um eine möglichst planare Abstützung zu erreichen, ist es vorteilhaft, wenn die Belichtungseinheit in Richtung auf die Maske justierbare Befestigungselemente zur Befestigung von senkrecht auf die Maske wirkenden stabförmigen Abstützelementen aufweist.

Für eine gleichmäßige Belichtung ist es auch von Vorteil, wenn die Abstützelemente aus einem für die verwendete Strahlung transparenten Material bestehen.

Um die Belichtung nicht zu beeinträchtigen, ist es günstig, wenn bei einer in mehrere Nutzen unterteilten Maske die Abstützelemente die Maske im Trennbereich zwischen den Nutzen abstützen.

Zweckmäßig ist die Oberseite der Vakuumkammer für die zu verwendende Strahlung zumindest teilweise transparent. Dabei kann die Belichtungseinrichtung durch die Oberseite der Vakuumkammer hindurch die die Unterseite der Vakuumkammer darstellende Maske vollflächig belichten.

Weiterhin kann es als Einzelmerkmal oder in Merkmalskombination vorgesehen sein, dass
- die Grundfläche der Vakuumkammer größer als die Grundfläche der Maske ist.
- die Oberseite der Vakuumkammer parallel zu der Unterseite der Vakuumkammer ausgerichtet ist.
- die Vakuumkammer einen Quader oder einen Pyramidenstumpf darstellt.
- das Verhältnis von Höhe zu Breite der Vakuumkammer im Bereich von 1:100 bis 1:2 liegt.
- die Unterseite der Vakuumkammer eine an die Form der Maske angepasste Öffnung aufweist.
- die Öffnung so an die Form der Maske angepasst ist, dass die Maske mit Ihrer Außenkante auf dem Rand der Öffnung gleichmäßig aufliegt und diese verschließt.
- die Maske über einen in der Vakuumkammer erzeugbaren Unterdruck an die Unterseite der Vakuumkammer gezogen wird und dort gehalten wird.
- die Maske mittels einer umlaufenden Dichtung an der Unterseite der Vakuumkammer an Ihrem Rand zur Vakuumkammer hin abgedichtet ist.
- die Vakuumkammer an ihrer Unterseite zur Positionierung und / oder Fixierung der Maske eine mechanische Vorrichtung beispielsweise mechanische Führungen und / oder Ausrichtelemente und / oder Halteklammern aufweist.
- die Oberseite der Vakuumkammer zumindest teilweise aus einem optisch transparenten Material beispielsweise aus einem Quarzglas oder einem Glas oder einem Kunststoff besteht.
- das optisch transparente Material der Oberseite eine planparallele Platte darstellt.
- das optisch transparente Material der Oberseite optische Elemente zur Lichtlenkung und / oder Lichtleitung beinhaltet.
- das optisch transparente Material der Oberseite wellenlängenselektiven Eigenschaften beispielsweise optische Filtereigenschaften aufweist.
- die Oberseite aus mehreren optisch transparenten Elementen besteht.
- die Vakuumkammer über einen Anschluss mit einem Unterdruckerzeuger verbunden ist.
- die Vakuumkammer eine Belüftungsvorrichtung aufweist.
- die Haltevorrichtung für die Abstützelemente in dem Rahmen zur Aufnahme der Maske oder im Inneren der Vakuumkammer angeordnet ist.
- die Haltevorrichtung Abstützelemente mit gleicher oder unterschiedlicher Ausführung aufnehmen kann.
- die Haltevorrichtung zumindest teilweise aus einem für die optische Nutzstrahlung transparentem Material besteht.
- die Abstützelemente aus einem für die Nutzstrahlung transparenten Material bestehen.
- die Anordnung und die Kombination der Abstützelemente veränderbar ist.
- die Abstützelemente eine optische Funktionalität aufweisen.
- die Abstützelemente als Lichtleiter und / oder als Linsen wirken.
- zumindest Teile der Abstützelemente als Spiegel wirken.
- die Abstützelemente als Leisten oder Barren ausgeführt sind.
- die Abstützelemente lotrecht und punktweise die Maske abstützende, zylindrische oder konisch geformte Stäbe oder Kegel darstellen.

Im Folgenden wird die Erfindung anhand der in der Zeichnung schematisch dargestellten Ausführungsbeispiele näher erläutert. Es zeigen:

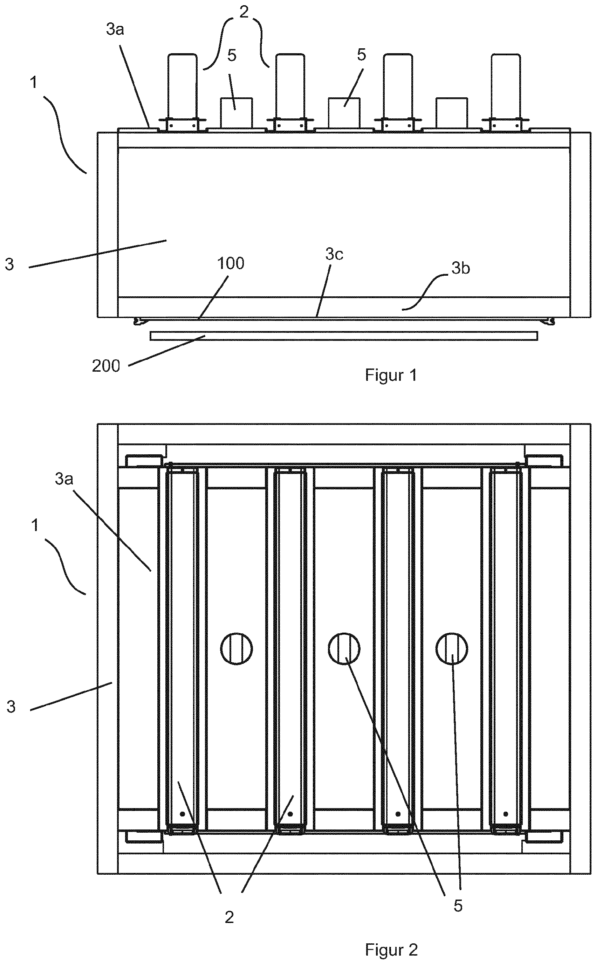

- Fig. 1: eine Vorrichtung zur Belichtung bzw. Bestrahlung eines Substrats in einer Seitenansicht
- Fig. 2: eine Draufsicht auf die Vorrichtung nach Fig. 1.
- Fig. 3: eine weitere detaillierte Seitenansicht der Belichtungsvorrichtung;
- Fig. 4: die Bestrahlungsvorrichtung in einer perspektivischen, teils geschnittenen Ansicht;
- Fig. 5: verschiedene Abstützgeometrien für Masken in perspektivischer Ansicht;
- Fig. 6: eine weitere Abstützvariante.

Das in der Zeichnung gezeigte Belichtungssystem 1 umfasst mehrere langgestreckte Belichtungseinheiten 2, welche an der Oberseite 3a einer Kammer 3 seitlich nebeneinander angeordnet sind. Die Kammer 3 weist an Ihrer Unterseite 3b eine Öffnung 3c auf, welche im Betrieb mit einer Maske 100 verschlossen ist, so dass die Kammer 3 mit einem Unterdruck beaufschlagt werden kann. Hierzu ist die Kammer 3 über Anschlussstutzen 5 und nicht dargestellte Verbindungsleitungen mit einem nicht dargestellten Unterdruckerzeuger verbunden. Der Unterdruck kann dabei beispielsweise mittels einer Vakuumpumpe oder einem Saug-Gebläse oder einem ähnlichen Verfahren erzeugt werden. Da die Belichtungsmaske 100 für die Belichtung des Substrats im Produktionsprozess je nach Anforderung nur einen geringen Abstand zwischen 0,1mm und 2mm mit einer nur geringen Toleranz von 0,1mm bis 0,5mm zum Substrat aufweisen darf, ist es erforderlich, die Maske 100 außenseitig der Kammer 3 an deren Unterseite 3b zu platzieren und zumindest dort festzuhalten.

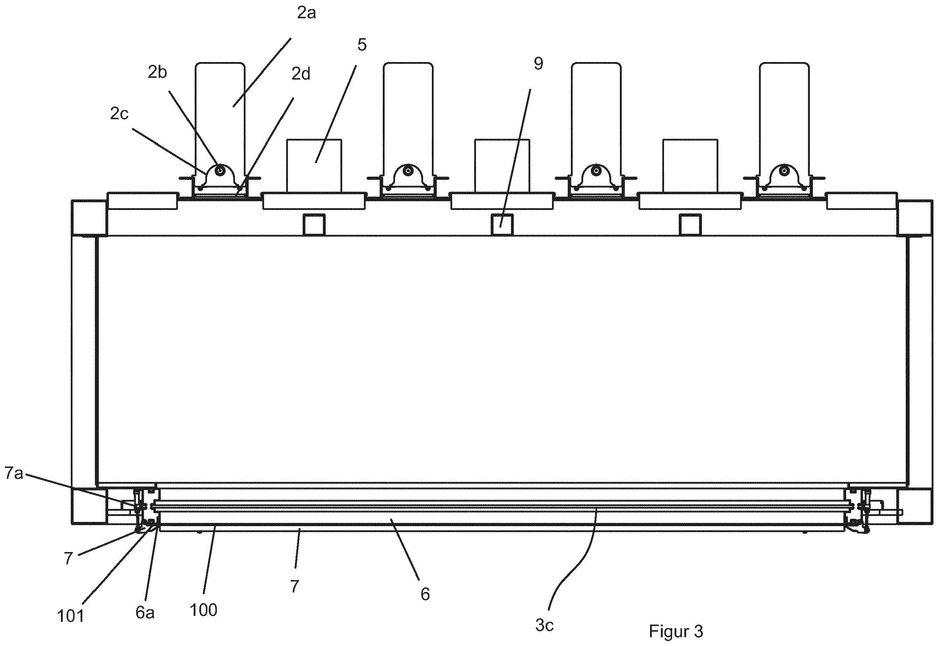

Hierzu liegt die Maske 100 wie in Figur 3 dargestellt mit Ihrer Außenkante 101 umlaufend auf einem umlaufenden Rahmen 6 als Aufnahme- und Haltevorrichtung auf, welcher in die Öffnung 3c einbringbar ist und in dieser über geeignete nicht dargestellte Halteelemente befestigt werden kann und dabei eine luftdichte Verbindung eingeht. Die Außenkante 101 der Maske 100 liegt dabei auf einem umlaufenden Dichtelement 6a, welches in eine Nut des Rahmens 6 eingebracht ist, so auf, dass bei einer Beaufschlagung des Innenraums der Kammer 3 mit einem Unterdruck die Maske an das Dichtelement 6a und damit auch an den Rahmen 6 angepresst wird und die Kammer zum Außenraum hin verschließt. Bei einer genügenden Unterdruckbeaufschlagung ist hierdurch auch gewährleistet, dass die Maske 100 an dem Rahmen 6 festgehalten wird.

Zur Unterstützung der Fixierung und zur Ausrichtung der Maske 100 in ihrer Position zum Rahmen 6, insbesondere bei einem Wechsel der Maske 100 sind weiterhin mechanische Halteleisten 7 und nicht dargestellte Anschlagkanten oder Ausrichtelemente vorgesehen, welche mittels gesteuerter Antriebe 7a an- oder abgestellt werden können. Die Halteleisten 7 pressen dabei die Außenkante 101 der Maske 100 unter einem geringen Druck so an das Dichtelement 6a, so dass eine nachfolgende Unterdruckbeaufschlagung der Kammer 3 problemlos erfolgen kann.

Aufgrund der Anforderung, den Abstand der Maske 100 und deren plane Ausrichtung zum Substrat 200 in möglichst engen Grenzen zu halten, ist es insbesondere bei einer Maskengröße von mehreren Quadratmetern vorgesehen, zusätzliche Abstützelemente im Inneren des Rahmens 6 bzw. der Kammer 3 so anzuordnen und so auszuführen, dass der Belichtungsprozess über die gesamte Fläche der Maske von den Abstützelementen im Wesentlichen nicht beeinträchtigt wird, wie es nachstehend näher erläutert wird.

Da unterschiedliche Masken eine unterschiedliche Anzahl von Nutzen und eine unterschiedliche Anordnung der Nutzen aufweisen und die Nutzen über jeweilige Trennbereiche voneinander getrennt sind, ist es von Vorteil, die Abstützelemente in die Trennbereiche zwischen die Nutzen zu platzieren. Hierdurch wird gewährleistet, dass die Abstützelemente die homogene Belichtung der Nutzen über die Maske nicht beeinträchtigen.

Zur Anpassung der Anordnung der Abstützelemente an unterschiedliche Masken mit unterschiedlicher Anzahl und Positionierung der Nutzen ist es daher vorgesehen, die Abstützelemente in dem Rahmen 6 anzuordnen und zu fixieren.

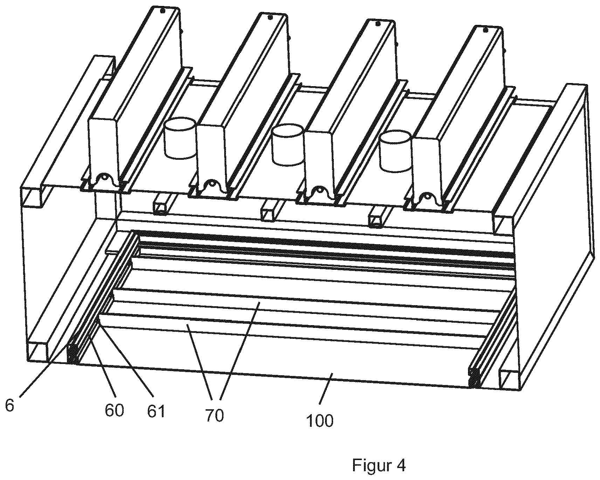

Wie in Fig. 4 gezeigt, weist der Rahmen 6 hierzu eine beispielsweise umlaufende Nut 60 auf, in welche stabförmige Abstützelemente 70 mit ihren stirnseitigen Enden eingelegt und dort mit entsprechenden Fixierelementen 61 fixiert werden können.

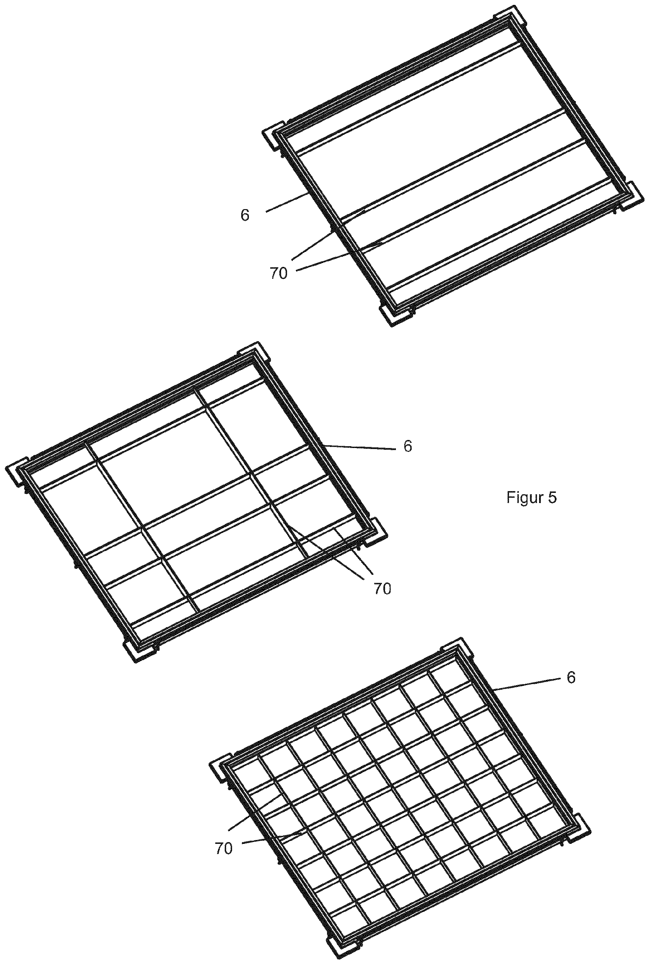

Durch die Verwendung von ineinander eingreifenden Abstützelementen 70 ist es möglich, wahlweise unterschiedliche Abstützgeometrien zu realisieren, wie beispielsweise in Figur 5 gezeigt. Es ist dabei auch möglich, unterschiedliche Rahmen 6 mit an jeweilige Masken 100 angepassten, unterschiedlich angeordneten Abstützelementen und Abstützgeometrien zu bevorraten und je nach Bedarf auszutauschen.

Die Abstützelemente 70 können dabei als dünne Stäbe mit einem runden oder rechteckigen Querschnitt ausgeführt sein, so dass sich bei einer horizontalen Einbaulage der Abstützelemente die Maske auf einer jeweiligen Kante der Abstützelemente 70 abstützt.

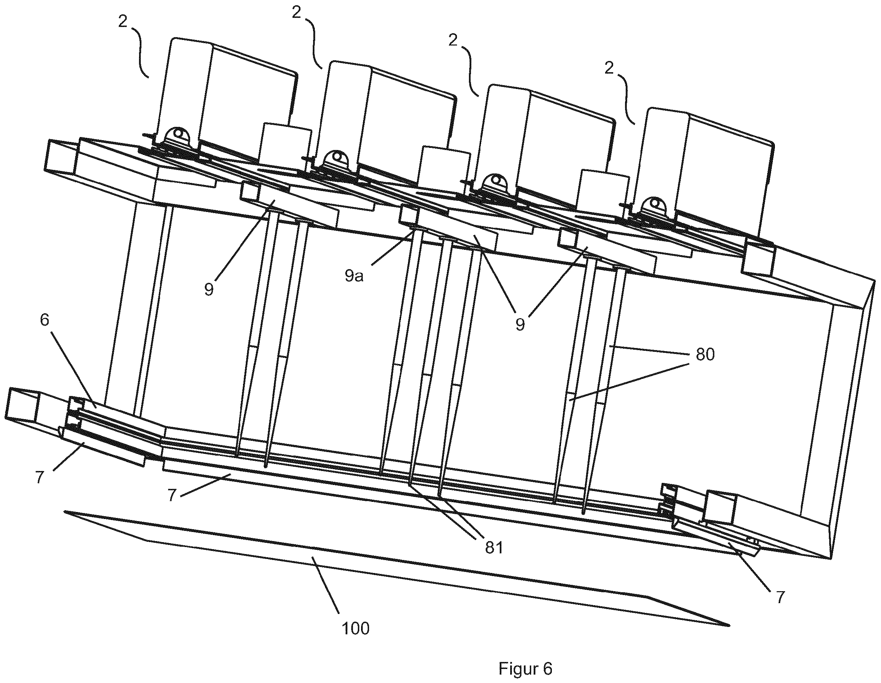

Wie in Fig. 6 gezeigt, kann es zur Abstützung der Maske gegen eine Verwölbung auch vorgesehen sein, anstelle von horizontal bzw. quer zur Bestrahlungsrichtung angeordneten Abstützelementen 70 eine Anzahl von vertikal angeordneten Abstützelementen 80 zu verwenden, so dass die Abstützung der Maske punktförmig über eine Vielzahl von Abstützpunkten 81 erfolgt. Hierzu sind die Abstützelemente 80 nicht in dem Rahmen 6 befestigt, sondern an einer in der Nähe der Oberseite der Kammer 3 angeordneten Halterung 9 einzeln oder gemeinsam befestigt, so dass deren Längsausdehnung im Wesentlichen in die Ausbreitungsrichtung der Nutzstrahlung der Belichtungseinheiten 2 weist. Hierzu weist die Halterung 9 eine Anzahl von Befestigungsvorrichtungen 9a auf, welche zur Befestigung jeweils wenigstens einer vertikalen Abstützung 80 dient.

Es kann dabei zweckmäßig sein, die Befestigungsvorrichtungen 9a jeweils mit einer Höhenverstelleinrichtung, beispielsweise einer Mikrometerschraube zu versehen, wodurch eine nachträgliche Anpassung der jeweiligen Abstützpunkte 81 in die Maskenebene ermöglicht wird, um so eine optimale Planarität der Maske in der Prozessebene zu ermöglichen. Es ist auch möglich, jeweils eine entsprechende motorische Verstelleinrichtung zu verwenden, welches über ein nicht eigens dargestelltes Einpunkt- oder Mehrpunkt-Abstandsmesssystem eine automatische Nachjustierung der Planität der Maske ermöglicht.

Die Abstützelemente 80 weisen dabei eine ausreichende Länge von ihrer Halterung in der Nähe der Oberseite der Kammer bis zur Maskenebene auf bei einem Durchmesser von <1mm bis > 10mm. Es kann dabei vorteilhaft sein, die Abstützelemente 80 zumindest in einem Teilbereich ihrer Länge konisch auszugestalten, vorzugsweise im Bereich der Maskenauflage. Hierdurch wird die Möglichkeit geschaffen die Maske an einer Vielzahl einzelner Punkte abzustützen, so dass eine Beeinträchtigung der Belichtung durch die Abstützelemente 80 minimiert wird. Hierzu ist die Spitze 81 der Abstützelemente 80 beispielsweise als plane Fläche oder als Kugelfläche oder als Freiformfläche ausgebildet, um eine mechanische Beschädigung der Maske 100 durch einen zu hohen Druck auf einen einzelnen Punkt auf der Maske 100 zu minimieren. Es kann dabei zweckmäßig sein, die Abstützpunkte 81 auf der Maske 100 ebenfalls in die Trennbereiche der Nutzen zu legen und die Auflageflächen der Abstützpunkte 81 flächig zu vergrößern, um die Gefahr einer Beschädigung der Maske weiter zu verringern.

Die Belichtungseinheiten 2 selbst enthalten einen oder mehrere Strahlungserzeuger wie beispielweise Glühlampen oder Gasentladungslampen oder Halbleiteremitter oder LED's oder Laser oder ähnliche Erzeugungsvorrichtungen für elektromagnetische Strahlung, welche in dem gewünschten Emissionsbereich eine ausreichende Strahlungsleistung aussenden. Die Strahlung kann dabei im EUV, VUV und / oder UV Bereich und / oder im visuellen und / oder infraroten Bereich liegen.

Wird für den Belichtungsprozess beispielsweise eine UV-Strahlung benötigt, so können die Belichtungseinheiten 2 beispielsweise einen oder mehrere Quecksilberstrahler 2b als Strahlungserzeuger aufweisen, deren Strahlung zur Erhöhung des gesamten Wirkungsgrads zusätzlich Reflektoren 2c auf der einem Belichtungsfenster 2d abgewandten Seite aufweisen (Fig. 3). Da insbesondere Mitteldruck- und Hochdruck-Quecksilberstrahler ein breites Spektrum vom UV bis in das Infrarot abstrahlen, kann es für die Belichtung dabei erforderlich sein, nur einen bestimmten Wellenlängenbereich zu selektieren, beispielsweise durch Verwendung von optischen Elementen. Hierzu sind beispielsweise die Reflektoren 2c als dielektrische Spiegel ausgeführt, welche nahezu ausschließlich den gewünschten Spektralbereich reflektieren, während das Belichtungsfenster 2d als dielektrisches Filter ausgeführt ist, welches fast ausschließlich nur den gewünschten Spektralbereich hindurch lässt.

Die Belichtungseinheiten 2 sind dabei oberhalb der Kammer 3 so angeordnet, dass die ausgesendete Strahlung durch die Belichtungsfenster 2d in das Innere der Kammer 3 eintritt und auf der Unterseite 3b durch die Öffnung 3c auf die Maske 100 trifft und an den transparenten Bereichen durch die Maske 100 hindurch auf das außerhalb der Kammer 3 unmittelbar unter der Maske 100 positionierte Substrat 200 trifft.

## Patentansprüche

1. Vorrichtung zur Belichtung eines Substrats (200) mit mindestens einer Belichtungseinheit (2) umfassend einen Strahlungserzeuger (2b) für elektromagnetische Strahlung und mit einer zumindest bereichsweise für die elektromagnetische Strahlung transparenten Maske (100) zur Übertragung einer in der Maske (100) beinhalteten Struktur oder Information auf das Substrat (200), wobei die Maske (100) über Abstützelemente (70,80) in einer planen und zum Substrat (200) parallelen Ausrichtung abgestützt ist, wobei die Maske (100) über eine Aufnahme- und Haltevorrichtung (6) mit der mindestens einen Belichtungseinheit (2) verbunden ist und daran durch Unterdruck gehalten ist, **dadurch gekennzeichnet, dass** die mindestens eine Belichtungseinheit (2) an einer Seite einer Unterdruckkammer (3) angeordnet ist und die Aufnahme- und Haltevorrichtung (6) sowie die Maske (100) auf der gegenüberliegenden anderen Seite der Unterdruckkammer (3) angeordnet sind, wobei die Maske (100) eine Durchstrahlöffnung (3c) der Unterdruckkammer (3) verschließt und die Abstützelemente (70,80) die Maske (100) über linienartige oder punktartige Auflagen im Bereich der Durchstrahlöffnunq (3c) abstützen.

2. Vorrichtung nach Anspruch 1, **dadurch gekennzeichnet, dass** die Maske (100) in einem vorzugsweise austauschbaren Halterahmen aufgenommen ist.

3. Vorrichtung nach Anspruch 1 oder 2, **dadurch gekennzeichnet, dass** Halterungen (60,61;9) zur Aufnahme und Fixierung der die Maske (100) abstützenden Abstützelemente (70,80) vorgesehen sind.

4. Vorrichtung nach Anspruch 2 oder 3, **dadurch gekennzeichnet, dass** die Abstützelemente (70,80) in dem Halterahmen variabel positionierbar und fixierbar sind.

5. Vorrichtung nach einem der Ansprüche 1 bis 4, **dadurch gekennzeichnet, dass** die Abstützelemente (70,80) als Stäbe mit gleicher oder unterschiedlicher Querschnittsfläche ausgeführt sind.

6. Vorrichtung nach einem der Ansprüche 1 bis 5, **dadurch gekennzeichnet, dass** die Abstützelemente (70,80) mit Aussparungen versehen sind und über die Aussparungen miteinander zu einer Gitterstruktur verbindbar sind.

7. Vorrichtung nach einem der Ansprüche 1 bis 6, **dadurch gekennzeichnet, dass** die Belichtungseinheit (2) in Richtung auf die Maske (100) justierbare Befestigungselemente zur Befestigung von senkrecht auf die Maske (100) wirkenden stabförmigen Abstützelementen (70,80) aufweist.

8. Vorrichtung nach einem der Ansprüche 1 bis 7, **dadurch gekennzeichnet, dass** die Abstützelemente (70,80) aus einem für die verwendete Strahlung transparenten Material bestehen.

9. Vorrichtung nach einem der Ansprüche 1 bis 8, **dadurch gekennzeichnet, dass** die Maske (100) in mehrere Nutzen unterteilt ist, und dass die Abstützelemente (70,80) die Maske (100) in Trennbereichen zwischen den Nutzen abstützen.

## Claims

1. Device for exposing a substrate (200) with at least one exposure unit (2) comprising a radiation generator (2b) for electromagnetic radiation and with a mask (100) which is transparent at least in regions to the electromagnetic radiation for transferring a structure or information contained in the mask (100) to the substrate (200), wherein the mask (100) is supported via supporting elements (70, 80) in a planar orientation parallel to the substrate (200), wherein the mask (100) is connected via a receiving and holding device (6) to the at least one exposure unit (2) and is held thereon by negative pressure, **characterized in that** the at least one exposure unit (2) is arranged on one side of a vacuum chamber (3) and the receiving and holding device (6) as well as the mask (100) are arranged on the opposite other side of the vacuum chamber (3), wherein the mask (100) closes a trans-irradiated opening (3c) of the vacuum chamber (3) and the support elements (70, 80) support the mask (100) via linear or punctiform supports in the area of the trans-irradiated opening (3c).

2. The device according to claim 1, **characterized in that** the mask (100) is accommodated in a preferably exchangeable holding frame.

3. The device according to claims 1 or 2, **characterized in that** holders (60, 61; 9) are provided for receiving and fixing the supporting elements (70, 80) supporting the mask (100).

4. The device according to claim 2 or 3, **characterized in that** the supporting elements (70, 80) can be variably positioned and fixed in the holding frame.

5. The device according to one of claims 1 to 4, **characterized in that** the supporting elements (70, 80) are designed as rods with the same or different cross-sectional area.

6. The device according to one of claims 1 to 5, **characterized in that** the supporting elements (70, 80) are provided with recesses and can be connected to one another via the recesses to form a lattice structure.

7. The device according to one of claims 1 to 6, **characterized in that** the exposure unit (2) has fastening elements which can be adjusted in the direction to the mask (100) for fastening rod-shaped support elements (70, 80) which act perpendicularly on the mask (100).

8. The device according to one of claims 1 to 7, **characterized in that** the support elements (70, 80) consist of a material which is transparent to the radiation used.

9. The device according to one of claims 1 to 8, **characterized in that** the mask (100) is subdivided into a plurality of panels, and **in that** the support elements (70, 80) support the mask (100) in separating regions between the panels.

## Revendications

1. Dispositif destiné à l'éclairage d'un substrat (200), équipé d'au moins une unité d'éclairage (2) comprenant un générateur de rayonnement (2b) pour un rayonnement électromagnétique et d'un masque (100) transparent, au moins dans certaines zones, pour le rayonnement électromagnétique, destiné à la transmission sur le substrat (200) d'une structure ou d'une information que contient le masque (100) ; dans lequel le masque (100) est supporté par l'intermédiaire d'éléments de support (70, 80) dans une orientation plane et parallèle au substrat (200) ; dans lequel le masque (100) est relié à ladite au moins une unité d'éclairage (2) par l'intermédiaire d'un dispositif de réception et de maintien (6) et y est maintenu à l'intervention d'une pression négative, **caractérisé en ce que** ladite au moins une unité d'éclairage (2) est disposé contre un côté d'une chambre de dépression (3) et le dispositif de réception et de maintien (6), ainsi que le masque (100), sont disposés sur l'autre côté opposé de la chambre de dépression (3) ; dans lequel le masque (100) obture une ouverture d'irradiation (3c) de la chambre de dépression (3) et les éléments de support (70, 80) supportent le masque (100) par l'intermédiaire de supports sous la forme de lignes ou sous la forme de points dans la zone de l'ouverture d'irradiation (3c).

2. Dispositif selon la revendication 1, **caractérisé en ce que** le masque (100) est logé dans un cadre de maintien, de préférence qui peut être échangé.

3. Dispositif selon la revendication 1 ou 2, **caractérisé en ce que** des dispositifs de maintien (60, 61 ; 9) sont prévus pour la réception et la fixation des éléments de support (70, 80) qui supportent le masque (100).

4. Dispositif selon la revendication 2 ou 3, **caractérisé en ce que** les éléments de support (70, 80) peuvent être disposés et peuvent être fixés de manière variable dans le cadre de maintien.

5. Dispositif selon l'une quelconque des revendications 1 à 4, **caractérisé en ce que** les éléments de support (70, 80) sont réalisés sous la forme de tiges possédant une surface en section transversale identique ou différente.

6. Dispositif selon l'une quelconque des revendications 1 à 5, **caractérisé en ce que** les éléments de support (70, 80) sont munis d'évidements et peuvent être reliés les uns aux autres par l'intermédiaire des évidements afin d'obtenir une structure en forme de grille.

7. Dispositif selon l'une quelconque des revendications 1 à 6, **caractérisé en ce que** l'unité d'éclairage (2) présente des éléments de fixation qui peuvent être ajustés dans la direction du masque (100), destinés à la fixation d'éléments de support (70, 80) en forme de tiges qui exercent leur action en direction perpendiculaire sur le masque (100).

8. Dispositif selon l'une quelconque des revendications 1 à 7, **caractérisé en ce que** les éléments de support (70, 80) sont constitués d'un matériau transparent pour le rayonnement utilisé.

9. Dispositif selon l'une quelconque des revendications 1 à 8, **caractérisé en ce que** le masque (100) est subdivisé en plusieurs découpes, et **en ce que** les éléments de support (70, 80) supportent le masque (100) dans des zones de séparation entre les découpes.
